# FASCICULE DE BREVET EUROPEEN

(11) **EP 4 068 606 B1**
(45) Date de publication et mention de la délivrance du brevet: **02.10.2024**
(21) Numéro de dépôt: 22163729.1
(22) Date de dépôt: 23.03.2022
(51) Int. Cl.: H02M 3/158

(54) **CONVERTISSEUR DE TENSION**
SPANNUNGSWANDLER
VOLTAGE CONVERTER

(30) Priorité: 31.03.2021 FR 2103300
(43) Date de publication de la demande: 05.10.2022
(73) Titulaire: STMicroelectronics (Rousset) SAS, 13790 Rousset (FR)
(72) Inventeur: ORTET, Sebastien, 13790 CHATEAUNEUF-LE-ROUGE (FR); DAVINO, Didier, 83910 POURRIERES (FR); COLLETTE, Remi, 13590 MEYREUIL (FR)
(74) Mandataire: Cabinet Beaumont

(56) Documents cités:
- US-A1- 2014 328 087
- US-A1- 2014 347 021
- US-A1- 2016 276 931
- US-A1- 2017 027 031
- YE-THEN CHANG ET AL: "Online Parameter Tuning Technique for Predictive Current-Mode Control Operating in Boundary Conduction Mode", IEEE TRANSACTIONS ON INDUSTRIAL ELECTRONICS, IEEE SERVICE CENTER, PISCATAWAY, NJ, USA, vol. 56, no. 8, 1 August 2009 (2009-08-01), pages 3214 - 3221, XP011262238, ISSN: 0278-0046

## Description

### Domaine technique

La présente description concerne de façon générale les circuits électroniques, et concerne plus particulièrement les convertisseurs de tension de type alimentation à découpage ("Switched Mode Power Supply") ou SMPS et leur fonctionnement.

### Technique antérieure

Dans un convertisseur à découpage, une tension d'alimentation du convertisseur est découpée (ou hachée) en commutant des transistors MOS ("Metal Oxide Semiconductor" - métal oxyde semiconducteur) de manière à mettre en oeuvre des phases d'accumulation d'énergie dans un ensemble (l'ensemble comprenant un élément inductif et un élément capacitif) et des phases de restitution de l'énergie accumulée dans cet ensemble.

Dans un convertisseur à découpage configuré pour pouvoir fonctionner en mode PFM, c'est-à-dire à modulation de fréquence d'impulsion ("Pulse Frequency Modulation"), chaque cycle de fonctionnement du convertisseur comprend une phase d'accumulation d'énergie dans l'ensemble suivie d'une phase de restitution d'énergie à la charge connectée au convertisseur. Pendant la phase d'accumulation d'énergie, le courant traversant l'élément inductif augmente. Pendant la phase de restitution d'énergie, le courant traversant l'élément inductif diminue. Pour chaque cycle de fonctionnement, il est souhaitable que le courant traversant l'élément inductif soit nul au début de la phase d'accumulation d'énergie et à la fin de la phase de restitution d'énergie.

Les convertisseurs à découpage connus, notamment de type PFM, présentent divers inconvénients.

De l'art antérieur pertinent pour la présente invention est le document US 2017/027031 A1 et YE-THEN CHANG ET AL: "Online Parameter Tuning Technique for Prédictive Current-Mode Control Operating in Boundary Conduction Mode",IEEE TRANSACTIONS ON INDUSTRIAL ELECTRONICS, IEEE SERVICE CENTER, PISCATAWAY, NJ, USA, vol. 56, no. 8, 1 août 2009 (2009-08-01), pages 3214-3221.

### Résumé de l'invention

Un mode de réalisation pallie tout ou partie des inconvénients des convertisseurs de tension connus.

Un mode de réalisation prévoit un convertisseur de tension configuré pour fonctionner par une succession de cycles de fonctionnement, chaque cycle comprenant une phase d'accumulation d'énergie et une phase de restitution d'énergie, le convertisseur étant configuré pour que la durée d'une des phases soit déterminée par la comparaison d'une rampe de tension et une première tension de référence, la pente de ladite rampe de tension dépendant du signe du courant dans une inductance à la fin du cycle de fonctionnement précédent.

Un autre mode de réalisation prévoit un procédé de commande d'un convertisseur de tension comprenant une succession de cycles de fonctionnement, chaque cycle comprenant une phase d'accumulation d'énergie et une phase de restitution d'énergie, la durée d'une des phases étant déterminée par la comparaison d'une rampe de tension et une première tension de référence, la pente de ladite rampe de tension dépendant du signe du courant dans une inductance à la fin du cycle de fonctionnement précédent.

Selon un mode de réalisation, ladite une des phases est la phase de restitution d'énergie.

Selon un mode de réalisation, le convertisseur est configuré pour rendre, d'un cycle à l'autre, la pente de ladite rampe de tension plus importante si le courant dans l'inductance est négatif, et moins importante si le courant dans l'inductance est positif.

Selon un mode de réalisation, le convertisseur comprend des premier et deuxième transistors reliés en série entre un premier noeud d'application d'une tension d'alimentation et un deuxième noeud d'application d'une deuxième tension de référence, les premier et deuxième transistors étant reliés l'un à l'autre par un troisième noeud, le troisième noeud étant relié à un quatrième noeud de sortie par l'inductance, le quatrième noeud de sortie étant relié au deuxième noeud d'application de la deuxième tension de référence par un premier condensateur.

Selon un mode de réalisation, le convertisseur comprend un premier circuit relié au troisième noeud configuré pour déterminer le signe du courant traversant l'inductance.

Selon un mode de réalisation, le premier circuit comprend des troisième et quatrième transistors reliés en série entre des cinquième et sixième noeuds, les troisième et quatrième transistors étant reliés l'un à l'autre par un septième noeud relié au troisième noeud, le cinquième noeud étant relié au premier noeud d'application de la tension d'alimentation par un premier élément résistif, et le sixième noeud est relié au deuxième noeud d'application de la tension de référence par un deuxième élément résistif, la borne de commande du troisième transistor étant reliée au deuxième noeud, et la borne de commande du quatrième transistor est reliée à un premier noeud, le deuxième circuit comprenant :
- un huitième noeud de sortie sur lequel est fourni un premier signal prenant une première valeur lorsque la tension sur le troisième noeud est supérieure à la première tension d'alimentation et une deuxième valeur lorsque la tension sur le troisième noeud est inférieure à la première tension d'alimentation ; et
- un neuvième noeud de sortie sur lequel est fourni un deuxième signal prenant une première valeur lorsque la tension sur le troisième noeud est inférieure à la deuxième tension et une deuxième valeur lorsque la tension sur le troisième noeud est supérieure à la deuxième tension.

Selon un mode de réalisation, le convertisseur comprend un deuxième circuit configuré pour générer la rampe de tension, la pente de la rampe de tension étant dépendante d'un troisième signal.

Selon un mode de réalisation, le deuxième circuit comprend un circuit capacitif à capacité variable configuré pour être chargé lors de la génération de la rampe, la capacité du circuit dépendant de la valeur du troisième signal.

Selon un mode de réalisation, le troisième signal a un nombre fini de valeur possibles, chaque valeur du signal correspondant à une valeur de capacité.

Selon un mode de réalisation, le convertisseur comprend un troisième circuit configuré pour déterminer la modification du troisième signal selon les valeurs des premier et deuxième signaux.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement un mode de réalisation d'un convertisseur de tension ;
la figure 2 est un ensemble de chronogrammes illustrant le fonctionnement du circuit de la figure 1 ;
la figure 3 représente plus en détails une partie du mode de réalisation de la figure 1 ;
la figure 4 est un ensemble de chronogrammes illustrant le fonctionnement du circuit de la figure 3 ;
la figure 5 est un ensemble de chronogrammes illustrant le fonctionnement du circuit de la figure 3 ;
la figure 6 représente plus en détails une autre partie du mode de réalisation de la figure 1 ; et
la figure 7 représente plus en détails une partie du mode de réalisation de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

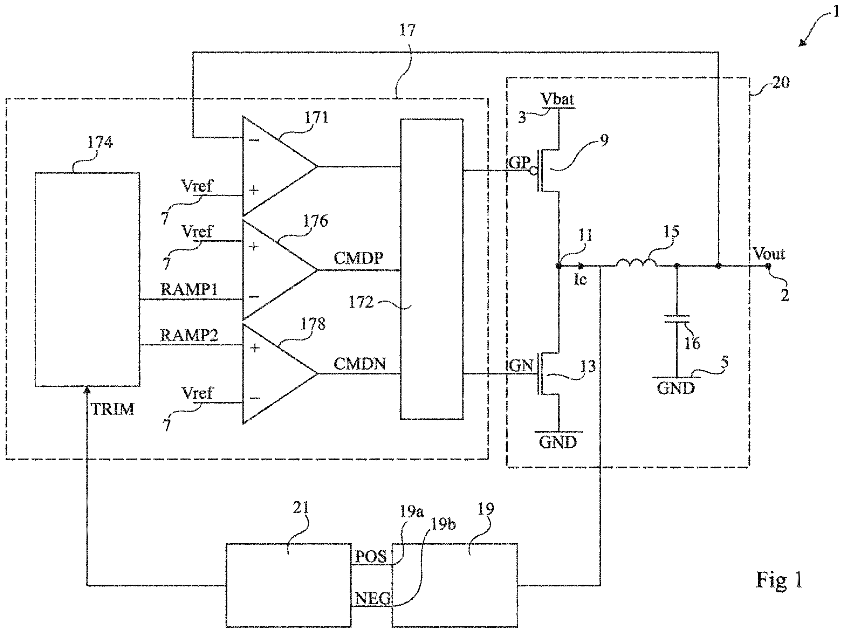

La figure 1 représente schématiquement un mode de réalisation d'un convertisseur de tension 1. Le convertisseur 1 est un convertisseur DC/DC, de type alimentation à découpage, qui convertit une tension continue (DC) d'alimentation en une tension continue (DC) de sortie.

Le convertisseur 1 est configuré pour fournir une tension continue de sortie Vout. Le convertisseur comprend un noeud de sortie 2, sur lequel est disponible la tension Vout.

Le convertisseur 1 est alimenté par une tension continue d'alimentation Vbat. Le convertisseur 1 est alors connecté entre un premier rail conducteur, ou noeud, 3 mis à la tension Vbat, et un deuxième rail conducteur, ou noeud, 5 mis à un potentiel de référence GND.

Le convertisseur 1 est configuré pour fournir la tension Vout à une valeur égale à une valeur de consigne. Pour cela, le convertisseur 1 reçoit, sur un noeud d'entrée 7, une tension continue de consigne Vref référencée par rapport au potentiel GND, dont la valeur est représentative de la valeur de consigne de la tension Vout, de préférence égale à la valeur de consigne de la tension Vout. La tension Vref est de préférence sensiblement constante durant le fonctionnement du convertisseur.

Dans cet exemple, les tensions Vout, Vbat et Vref sont positives. Dans cet exemple, les tensions Vout, Vbat et Vref sont référencées au potentiel GND, par exemple la masse.

Dans cet exemple, le convertisseur 1 est de type abaisseur ou buck, c'est-à-dire que la valeur de consigne de la tension Vout est inférieure à la valeur de la tension Vbat. Autrement dit, la valeur de la tension Vout est inférieure à celle de la tension Vbat.

Le convertisseur 1 comprend un étage de puissance 20. L'étage de puissance 20 comprend un premier transistor MOS ("métal oxyde semiconductor" - métal oxyde semiconducteur) 9, de préférence un transistor PMOS (transistor MOS à canal P). Le transistor MOS 9 est relié, de préférence connecté, entre le rail 3 et un noeud interne 11. Autrement dit, une première borne de conduction du transistor 9, par exemple sa source, est reliée, de préférence connectée, au rail 3, une deuxième borne de conduction du transistor 9, par exemple son drain, étant reliée, de préférence connectée, au noeud 11.

L'étage 20 comprend en outre un deuxième transistor MOS 13, de préférence un transistor NMOS (transistor MOS à canal N). Le transistor 13 est relié, de préférence connecté, entre le noeud 11 et le rail 5. Autrement dit, une première borne de conduction du transistor 13, par exemple sa source, est reliée, de préférence connectée, au rail 5, une deuxième borne de conduction du transistor 13, par exemple son drain, étant reliée, de préférence connectée, au noeud 11. A titre de variante, le transistor NMOS peut être remplacé par une diode ou une diode Schottky.

Ainsi, les transistors 9 et 13 sont connectés en série entre les rails 3 et 5, et sont connectés l'un à l'autre au niveau du noeud interne 11.

Chacun des transistors 9 et 13 comprend une diode intrinsèque non représentée. Les diodes intrinsèques non représentées sont par exemple reliées en série entre le rail 3 et le rail 5. Plus précisément, une première borne, anode ou cathode, de la diode intrinsèque du transistor 13 est reliée, de préférence connectée, au rail 5 et une deuxième borne, cathode ou anode, de ladite diode est reliée, de préférence connectée, au noeud 11. Une première borne, anode ou cathode, de la diode intrinsèque du transistor 9 est reliée, de préférence connectée, au noeud 11 et une deuxième borne, cathode ou anode, de ladite diode est reliée, de préférence connectée, au rail 3. Les première bornes des diodes intrinsèques sont par exemple les anodes et les deuxièmes bornes des diodes intrinsèques sont par exemple les cathodes. Le noeud 11 est ainsi relié à l'anode d'une des diodes et à la cathode de l'autre diode.

L'étage 20 comprend un élément inductif ou inductance 15. L'inductance 15 est connectée entre le noeud 11 et le noeud 2. Le convertisseur 1 comprend un élément capacitif ou condensateur de sortie 16 connecté entre le noeud 2 et le rail 5. A titre d'exemple, la capacité de l'élément capacitif est supérieure à 2 µF, de préférence compris entre 2,2 µF à 20 µF, voire plus. Ce condensateur de sortie 16 joue le rôle de filtre. Autrement dit, ce condensateur de sortie du convertisseur permet de lisser le courant présent sur le noeud 2 et de stocker de l'énergie fournie au noeud 2 par le convertisseur.

En fonctionnement, une charge non représentée est connectée entre le noeud 2 et le rail 5 de manière à être alimentée par la tension Vout.

Le convertisseur 1 comprend un circuit de commande 17. Le circuit 17 est configuré pour mettre en oeuvre, ou commander, les cycles de fonctionnement du convertisseur 1, de manière à réguler la tension Vout pour que sa valeur soit égale à la valeur de consigne Vref. Le circuit 17 comprend un circuit 172, par exemple une machine d'état configurée pour générer les signaux de commande des transistors 9 et 13. Ainsi, une sortie du circuit 172 est reliée, de préférence connectée, à une borne de commande du transistor 9 et fournit un signal GP de commande du transistor 9. Similairement, une sortie du circuit 172 est reliée, de préférence connectée, à une borne de commande du transistor 13 et fournit un signal GN de commande du transistor 13.

Le convertisseur 1 est par exemple configuré pour fonctionner en modulation de fréquence d'impulsion (mode de conduction discontinue). Le circuit 17 est alors configuré pour démarrer un cycle de fonctionnement du convertisseur 1 quand la valeur de la tension Vout est inférieure à la valeur de consigne Vref et que les deux transistors 9 et 13 sont à l'état bloqué.

Pour ce faire, le circuit 17 comprend par exemple un comparateur 171 configuré pour comparer la tension Vout et la tension de consigne Vref. Le comparateur 171 comprend une entrée, par exemple une entrée inverseuse, reliée, de préférence connectée, au noeud 2. Le comparateur 171 comprend une autre entrée, par exemple une entrée non inverseuse, reliée, de préférence connectée, au noeud 7. Une sortie du comparateur 171 est reliée, de préférence connectée, au circuit 172, et fourni un signal représentatif de la différence entre la tension Vref et la tension Vout.

Plus particulièrement, au début de chaque cycle de fonctionnement, signifié par le signal de sortie du comparateur 171, le circuit 17 est configuré pour commander le début d'une phase d'accumulation d'énergie, c'est-à-dire la mise à l'état passant du transistor 9, le transistor 13 étant laissé à l'état bloqué. De l'énergie est alors accumulée dans l'inductance 15 et dans la capacité 16, pendant une première durée TPon, un courant Ic circulant alors dans l'inductance 15. A la fin de la durée TPon, le circuit 17 est configuré pour commander la mise à l'état bloqué du transistor 9 et la mise à l'état passant du transistor 13. De l'énergie est alors restituée par l'inductance 15 et la capacité 16, à la charge connectée en sortie du convertisseur, pendant une deuxième durée TNon, le courant Ic dans l'inductance diminuant. A la fin de la durée TNon, le circuit 17 est configuré pour commander la mise à l'état bloqué du transistor 13.

Les durées TPon et TNon sont déterminées en comparant des rampes de tensions à une valeur de référence, par exemple la tension de consigne Vref. Ainsi, le circuit 17 comprend un circuit 174 de génération de rampes de tension. Le circuit 174 est configuré pour générer une rampe de tension RAMP1 et une rampe de tension RAMP2.

La rampe de tension RAMP1 est par exemple une rampe croissante, commençant à une valeur basse inférieure à la tension Vref. La rampe de tension RAMP2 est par exemple une rampe décroissante, commençant à une valeur haute, supérieure à la valeur Vref.

Le circuit 17 comprend un comparateur 176. Le comparateur 176 comprend une entrée, de préférence une entrée non inverseuse, reliée, de préférence connectée, au noeud 7. Le comparateur 176 comprend une autre entrée, de préférence une entrée inverseuse, reliée, de préférence connectée, à une sortie du circuit 174 sur laquelle est fournie la rampe de tension RAMP1. Le comparateur 176 comprend une sortie sur laquelle est fourni un signal CMDP, par exemple un signal binaire, représentatif de la différence entre la tension Vref et la rampe RAMP1. Plus précisément, le signal CMDP indique que la rampe RAMP1 atteint la valeur de la tension Vref.

Le circuit 17 comprend un comparateur 178. Le comparateur 178 comprend une entrée, de préférence une entrée inverseuse, reliée, de préférence connectée, au noeud 7. Le comparateur 178 comprend une autre entrée, de préférence une entrée non inverseuse, reliée, de préférence connectée, à une sortie du circuit 174 sur laquelle est fournie la rampe de tension RAMP2. Le comparateur 178 comprend une sortie sur laquelle est fourni un signal CMDN, par exemple un signal binaire, représentatif de la différence entre la tension Vref et la rampe RAMP2. Plus précisément, le signal CMDN indique que la rampe RAMP2 atteint la valeur de la tension Vref.

Ainsi, durant le fonctionnement du convertisseur 1, lors d'un début de cycle, par exemple déterminé par le comparateur 171, la phase d'accumulation d'énergie commence et la rampe RAMP1 commence à croitre à partir de la valeur basse. Lorsque la rampe RAMP1 atteint la valeur Vref, le signal CMDP passe d'une première valeur à une deuxième valeur, indiquant la fin de la phase d'accumulation d'énergie. Ainsi, la durée TPon correspond à la durée de croissance de la rampe RAMP1 entre la valeur basse et la valeur Vref. A la fin de la phase d'accumulation d'énergie, la phase de restitution d'énergie commence, c'est-à-dire que les états des transistors sont inversés, le transistor 9 devenant bloqué et le transistor 13 devenant passant. De plus, la rampe RAMP2 commence à décroître à partir de la valeur haute. Lorsque la rampe RAMP2 atteint la valeur Vref, le signal CMDN passe d'une première valeur à une deuxième valeur, indiquant la fin de la phase de restitution d'énergie. Ainsi, la durée TNon correspond à la durée de décroissance de la rampe RAMP2 entre la valeur haute et la valeur Vref. La fin de la phase de restitution d'énergie correspond à la fin du cycle. Les transistors 9 et 13 sont alors mis en état bloqués et le noeud 11 est dans un état de haute impédance jusqu'à ce que la tension Vout descende de nouveau sous la valeur de la tension Vref.

Le circuit 174 est configuré pour permettre de modifier ou ajuster la pente d'au moins une des rampes de tension, par exemple la rampe RAMP2. Il est ainsi possible de modifier la durée d'au moins une des phases, par exemple la phase de restitution d'énergie. Le circuit 174 est configuré pour que la pente d'au moins une des rampes de tension, par exemple la rampe RAMP2, soit modifiée de manière à obtenir un courant nul dans l'inductance à la fin des cycles de fonctionnement.

Le convertisseur 1 comprend un circuit 19 configuré pour déterminer si le courant traversant l'inductance 15 est positif ou négatif. En particulier, le circuit 19 est configuré pour déterminer le signe, positif ou négatif, du courant dans l'inductance 15 à la fin de chaque cycle de fonctionnement, c'est-à-dire à la fin de chaque phase de restitution d'énergie.

Dans le mode de réalisation de la figure 1, le circuit 19 comprend une entrée reliée, de préférence connectée, au noeud 11. Le circuit 19 comprend par exemple une sortie 19a sur laquelle est fourni un signal POS indiquant que le courant dans l'inductance 15 est positif et une entrée 19b sur laquelle est fourni un signal NEG indiquant que le courant dans l'inductance 15 est négatif.

Le convertisseur 1 comprend en outre un circuit 21 configuré pour déterminer, à partir des signaux POS et NEG, la modification à effectuer sur la ou les pentes des rampes de tension. Le circuit 21 comprend deux entrées, une entrée reliée, de préférence connectée, à la sortie 19a du circuit 19 sur laquelle est reçu le signal POS et une entrée reliée, de préférence connectée, à la sortie 19b du circuit 19 sur laquelle est fourni le signal NEG. Le circuit 21 comprend une sortie sur laquelle est fourni un signal TRIM représentatif des modifications à effectuer sur au moins une pente de rampe de tension. La sortie du circuit 21 est reliée, de préférence connectée, à une entrée du circuit 174.

Selon un mode de réalisation, la pente de la rampe de tension RAMP1 n'est pas modifiée d'un cycle sur l'autre. La pente de la rampe de tension RAMP1 est donc sensiblement constante d'un cycle sur l'autre. La pente de la rampe RAMP2 peut être modifiée d'un cycle sur l'autre, selon le signe du courant traversant l'inductance 15 en fin de cycle. Le circuit 174 est par exemple configuré pour un nombre fini de valeurs de pente de la rampe RAMP2. La rampe RAMP2 peut être générée par le circuit 174 avec une pente ayant une valeur parmi N valeurs distinctes de pentes possibles. Les différentes pentes possibles vont par exemple d'une valeur de pente V1 à une valeur de pente VN, la valeur V1 étant par exemple la moins inclinée et la valeur VN étant par exemple la plus inclinée.

Par exemple, si le courant dans l'inductance 15 est positif à la fin d'un cycle, toute l'énergie n'a pas été restituée. La pente de la rampe RAMP2 est donc, au cycle suivant, modifiée de manière à être moins raide, c'est-à-dire de manière à avoir une inclinaison plus faible. Par exemple, on passe d'une valeur Vi de pente, à une valeur Vi-1. Autrement dit, la pente est diminuée jusqu'à la valeur inférieure la plus proche. La phase de restitution d'énergie est ainsi plus longue.

Similairement, si le courant dans l'inductance 15 est négatif à la fin d'un cycle, trop d'énergie a été restituée. La pente de la rampe RAMP2 est donc, au cycle suivant, modifiée de manière à être plus raide, c'est-à-dire de manière à avoir une inclinaison plus importante. Par exemple, on passe d'une valeur Vi de pente, à une valeur Vi+1. Autrement dit, la pente est augmentée jusqu'à la valeur supérieure la plus proche. La phase d'accumulation d'énergie est ainsi moins longue.

De préférence, lorsque le convertisseur démarre la valeur de la pente a une valeur centrale, ou médiane, c'est-à-dire qu'il y a autant de valeurs inférieures que de valeurs supérieures. De préférence, cette valeur centrale est égale ou sensiblement égale à la valeur de la pente de la rampe RAMP1.

Selon un autre mode de réalisation, la pente de la rampe RAMP2 n'est pas modifiée d'un cycle sur l'autre, et la pente de la rampe RAMP1 est modifiée d'un cycle sur l'autre. Le fonctionnement est alors similaire au fonctionnement décrit ci-dessus, à l'exception du fait que l'inclinaison de la pente de la rampe RAMP1 devient plus importante si le courant dans l'inductance 15 est positif, et devient plus faible si le courant dans l'inductance 15 est négatif en fin de cycle.

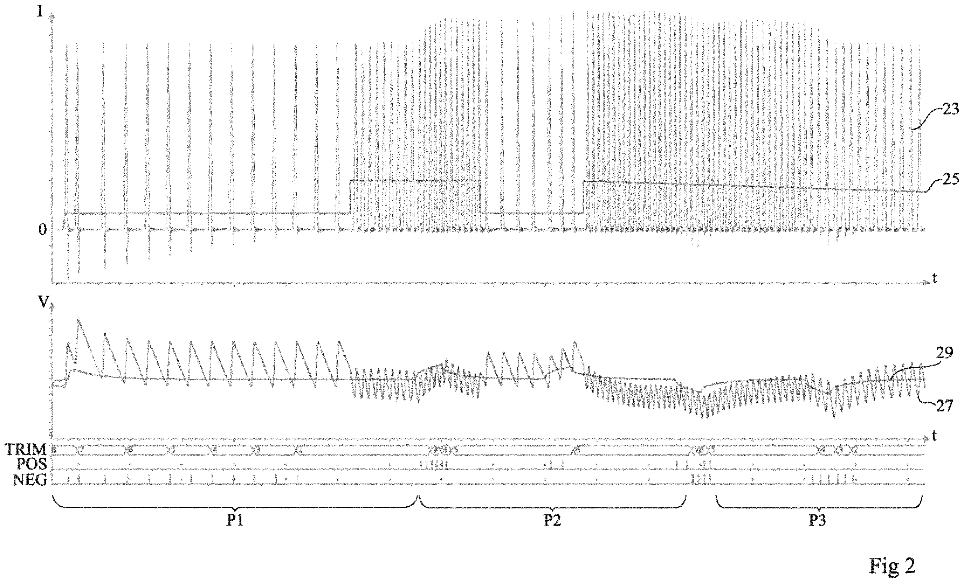

La figure 2 est un ensemble de chronogrammes illustrant le fonctionnement du circuit de la figure 1. La figure 2 comprend un chronogramme illustrant des courants (I) en fonction du temps (t). Plus précisément, le chronogramme illustre le courant Ic dans l'inductance 15 par une courbe 23 et illustre le courant tiré par la charge non représentée par une courbe 25. La figure 2 comprend de plus un chronogramme illustrant des tensions (V) en fonction du temps (t). Plus précisément, le chronogramme illustre la tension de sortie Vout par une courbe 27 et la tension de consigne Vref par une courbe 29. La figure 2 comprend en outre des chronogrammes illustrant les signaux TRIM, POS et NEG.

Les valeurs du signal TRIM sont, dans cet exemple, associées à des valeurs de pente. Ainsi, si le signal TRIM a une valeur égale à 8, la pente a une valeur V8.

On peut observer qu'à chaque fin de cycle de fonctionnement, qui correspond à un minimum de la courbe 29, une impulsion, c'est-à-dire une commutation du signal à la valeur haute pendant une durée de quelques nanosecondes, survient sur le signal POS si le courant Ic est positif et une impulsion survient sur le signal NEG si le signal Ic est négatif.

Dans l'exemple de la figure 2, la valeur du signal TRIM est modifiée si deux impulsions successives surviennent sur le signal NEG, ou sur le signal POS. De manière plus générale, la valeur du signal TRIM peut être modifiée à chaque cycle, ou tous les N cycles, N tant un entier par exemple au moins égal à 2.

Ainsi, dans une phase P1, le courant Ic est inférieur à 0 à la fin des cycles de fonctionnement, ce qui entraine la formation d'impulsion sur le signal NEG. Toutes les deux impulsions du signal NEG, dans l'exemple de la figure 2, la valeur du signal TRIM diminue d'une valeur constante, par exemple le pas d'un compteur, par exemple 1. On peut alors observer que la valeur négative maximale du courant Ic en fin de cycle se rapproche de 0 au cours de la phase P1 avec les modifications de la valeur de TRIM et donc la modification de la pente de la rampe RAMP2. Ainsi, sur la fin de la phase P1, la valeur du courant Ic en fin de cycle est sensiblement égale à 0.

Similairement, dans une phase P2, ultérieure à la phase P1, le courant Ic est supérieur à 0 à la fin des cycles de fonctionnement, ce qui entraine la formation d'impulsion sur le signal POS. Le passage de la phase P1 à la phase P2 est par exemple causé par une augmentation du courant tiré par la charge, illustré par la courbe 25. Cette augmentation est par exemple causée par une modification de la tension d'alimentation. Toutes les deux impulsions du signal POS, la valeur du signal TRIM augmente d'une valeur constante, par exemple 1. On peut alors observer que la valeur positive du courant Ic en fin de cycle diminue au cours de la phase P1 avec les modifications de la valeur de TRIM et donc la modification de la pente de la rampe RAMP2.

La figure 2 représente une phase P3 similaire à la phase P1.

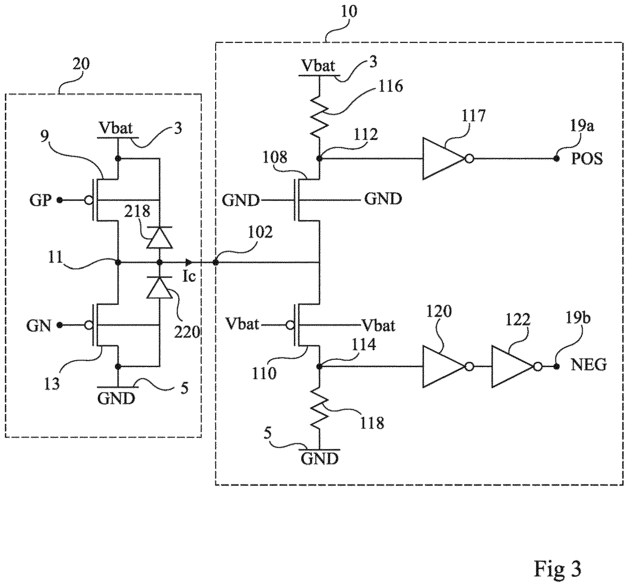

La figure 3 représente plus en détails un exemple d'implémentation d'une partie du mode de réalisation de la figure 1. Plus précisément, la figure 3 représente le circuit 19 et le circuit 20 plus en détails. Le circuit 19 est configuré pour déterminer si une tension d'entrée est dans une gamme de tensions. Autrement dit, le circuit 19 est configuré pour comparer ladite tension d'entrée à des premier et deuxième seuils de tension, différents l'un de l'autre.

Le circuit 20 est identique au circuit 20 représenté en figure 1, à l'exception du fait que le circuit 20 comprend, en figure 3, deux diodes 218 et 220 qui n'étaient pas représentées en figure 1. Les diodes 218 et 220 sont reliées en série entre le rail 3 et le rail 5. Plus précisément, une première borne, anode ou cathode, de la diode 220 est reliée, de préférence connectée, au rail 5 et une deuxième borne, cathode ou anode, de la diode 220 est reliée, de préférence connectée, au noeud 11. Une première borne, anode ou cathode, de la diode 218 est reliée, de préférence connectée, au noeud 11 et une deuxième borne, cathode ou anode, de la diode 218 est reliée, de préférence connectée, au rail 3. Dans l'exemple de la figure 3, les première bornes des diodes 218 et 220 sont les anodes et les deuxièmes bornes des diodes 218 et 220 sont les cathodes. Le noeud 11 est ainsi relié à l'anode d'une des diodes et à la cathode de l'autre diode.

Autrement dit, chaque diode est reliée, de préférence connectée, en parallèle avec un des transistors 9 et 13. Par exemple, l'anode de la diode 218 est reliée, de préférence connectée, à la source du transistor 9 et la cathode de la diode 218 est reliée, de préférence connectée, au drain du transistor 9. Similairement, l'anode de la diode 220 est reliée, de préférence connectée, à la source du transistor 13 et la cathode de la diode 220 est reliée, de préférence connectée, au drain du transistor 13. Par exemple, la cathode de la diode 218 est aussi reliée, de préférence connectée, au substrat du transistor 9. L'anode de la diode 220 est aussi, par exemple, reliée, de préférence connectée, au substrat du transistor 13. De préférence, les diodes 218 et 220 sont respectivement les diodes intrinsèques des transistors 9 et 13.

Le circuit 10 comprend une entrée 102 reliée, de préférence connectée, au noeud 11 et deux sorties 19a et 19b. L'entrée 102 reçoit une tension VLX, que l'on souhaite comparer à la gamme de tensions, et plus précisément, que l'on souhaite comparer aux premier et deuxième seuils de tension. Dans l'exemple de la figure 3, les premier et deuxième seuils sont respectivement la tension positive d'alimentation Vbat du convertisseur 1 et une tension de référence GND, de préférence la masse. La sortie 19a fournit un signal POS, de préférence binaire, et la sortie 19b fournit un signal NEG de préférence binaire. Lorsque le circuit 10 détermine que la tension d'entrée est supérieure, par exemple d'une valeur sensiblement égale à un seuil de diode, au premier seuil Vbat de la gamme, le signal NEG prend une première valeur, par exemple une valeur haute. Si la tension d'entrée est inférieure au premier seuil Vbat, la tension NEG prend une deuxième valeur, par exemple une valeur basse. Lorsque le circuit 10 détermine que la tension d'entrée est inférieure, par exemple d'une valeur sensiblement égale à un seuil de diode, au deuxième seuil de la gamme, le signal POS prend une première valeur, par exemple une valeur haute. Si la tension d'entrée est supérieure au deuxième seuil, la tension POS prend une deuxième valeur, par exemple une valeur basse.

Ainsi, si les signaux POS et NEG ont tous deux une valeur basse, cela signifie que la tension d'entrée est comprise entre les premier et deuxième seuils. Si le signal NEG a une valeur haute et le signal POS a une valeur basse, la tension d'entrée a une valeur supérieure au premier seuil. Si le signal NEG a une valeur basse et le signal POS a une valeur haute, la tension d'entrée a une valeur inférieure au deuxième seuil.

Le circuit 10 comprend deux transistors 108 et 110 reliés en série entre les rails 3 et 5. Plus précisément, une des bornes de conduction, source ou drain, du transistor 108 est reliée, de préférence connectée, à un noeud 112. L'autre borne de conduction du transistor 108, drain ou source, est reliée, de préférence connectée, au noeud d'entrée 102. Une des bornes de conduction du transistor 110, source ou drain, est reliée, de préférence connectée, au noeud 102. L'autre borne de conduction du transistor 110, drain ou source, est reliée, de préférence connectée, à un noeud 114.

De préférence, le transistor 110 est un transistor est un transistor à effet de champ de type P, ou PMOS, et le transistor 108 est un transistor à effet de champ de type N, ou NMOS. De préférence, les transistors 108 et 110 sont reliés, de préférence connectés, au noeud 102, par leurs sources respectives.

Le transistor 108 est commandé par une tension dont la valeur est sensiblement égale, de préférence égale, au deuxième seuil de tension, ici la tension de référence GND. Autrement dit, la borne de commande, ou grille, du transistor 108 est reliée au rail 5 d'application de la tension GND. Le transistor 110 est commandé par une tension dont la valeur est sensiblement égale, de préférence égale, au premier seuil de tension, ici la tension d'alimentation Vbat. Autrement dit, la borne de commande, ou grille, du transistor 110 est reliée au rail 3 d'application de la tension Vbat.

Le noeud 112 est relié au rail 3, de préférence par un élément résistif, ou résistance, 116. Le noeud 112 est aussi relié au noeud de sortie 19a, de préférence par un circuit, ou inverseur, 117 configuré pour inverser les signaux binaires. Ainsi, lorsque le circuit 117 reçoit une valeur basse en entrée, il fournit une valeur haute en sortie et inversement.

Le noeud 114 est relié au rail 5, de préférence par un élément résistif, ou résistance, 118. Le noeud 114 est aussi relié au noeud de sortie 19b, de préférence par deux circuits, ou inverseurs, 120 et 122 en série configurés pour inverser les signaux binaires.

L'élément résistif 116, le transistor 108, le transistor 110 et l'élément résistif 118 sont ainsi reliés en série dans cet ordre entre le rail 3 et le rail 5.

Les circuits 117, 120 et 122 permettent d'assurer que les signaux POS et NEG soient des signaux binaires ayant des valeurs hautes et basses reconnaissables.

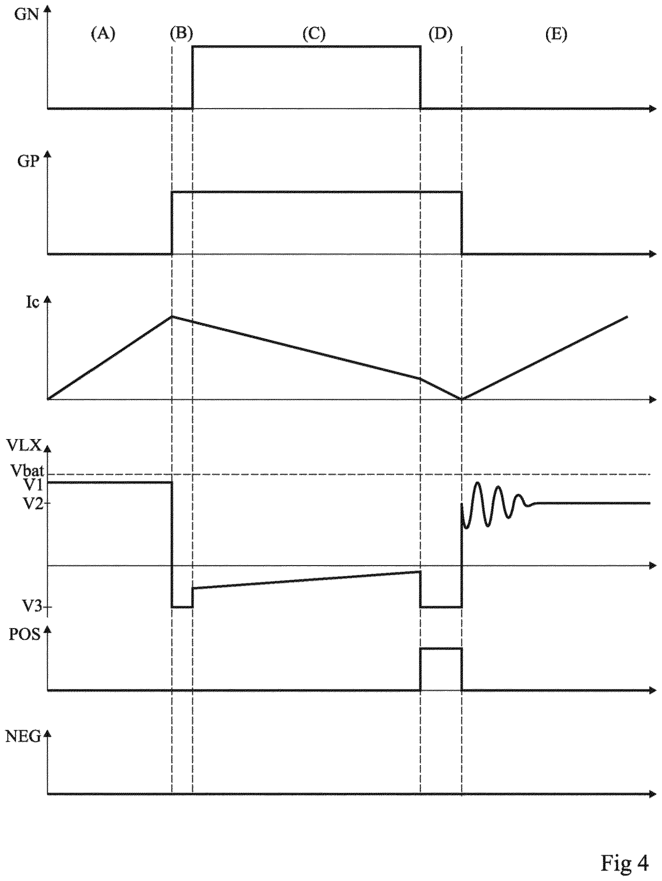

La figure 4 est un ensemble de chronogrammes illustrant le fonctionnement du circuit de la figure 3. Plus précisément, la figure 4 représente le comportement des signaux de commande GN, GP, du courant Ic, de la tension VLX sur le noeud 11, et les signaux POS et NEG, pendant un cycle de fonctionnement du circuit 20 de la figure 1 et pendant une partie (E) d'un cycle suivant. Le cycle de fonctionnement comprend par exemple quatre phases : une phase (A) d'accumulation d'énergie dans l'élément inductif 15 non représenté en figure 4, une phase (B) intermédiaire, une phase (C) de restitution d'énergie, et une phase (D) de compensation.

Au cours de la phase (A) d'accumulation d'énergie, le transistor 9 est passant et le transistor 13 est bloqué. Cela correspond, dans le mode de réalisation de la figure 1, au signal de commande GN ayant une valeur basse et au signal de commande GP ayant une valeur basse. La tension VLX a donc une valeur V1 positive, inférieure à la valeur Vbat. Ainsi, durant la phase (A), le courant Ic traversant l'élément inductif non représenté en figure 1 non représentée augmente.

La tension VLX étant inférieure à la tension de commande du transistor 110, c'est-à-dire la tension d'alimentation Vbat, la tension grille-source du transistor 110 est positive. Le transistor 110 reste donc bloqué durant la phase (A). Ainsi, la tension sur le noeud 114 a une valeur basse, par exemple sensiblement égale à la tension de référence GND. Le signal NEG, en sortie des inverseurs 120 et 122 a donc une valeur basse.

Similairement, la tension VLX est supérieure à la tension de commande du transistor 108, c'est-à-dire la tension de référence GND, la tension grille-source du transistor 108 est négative. Le transistor 108 reste donc bloqué durant la phase (A). Ainsi, la tension sur le noeud 112 a une valeur haute, par exemple sensiblement égale à la tension Vbat. Le signal POS, en sortie de l'inverseur 117, a donc une valeur basse.

Au cours de la phase (B), les transistors 13 et 9 sont bloqués. Cela correspond, dans le mode de réalisation de la figure 1, au signal de commande GN ayant une valeur basse et au signal de commande GP ayant une valeur haute. La phase (B) est une phase intermédiaire permettant d'assurer que les transistors 9 et 13 ne soient pas passants simultanément. Au cours de la phase (B), le noeud 11 n'est plus alimenté par le rail 3. Le courant Ic diminue donc. Le courant Ic est positif et les transistors 9 et 13 sont bloqués. Le courant IC traverse donc la diode 220. La tension VLX prend une valeur V3 négative.

La tension VLX étant inférieure à la tension de commande du transistor 110, c'est-à-dire la tension d'alimentation Vbat, la tension grille-source du transistor 110 est positive. Le transistor 110 reste donc bloqué durant la phase (B). Ainsi, la tension sur le noeud 114 est une valeur basse, par exemple sensiblement égale à la tension de référence GND. Le signal NEG, en sortie des inverseurs 120 et 122 a donc une valeur basse.

La tension VLX est négative. Autrement dit, la tension VLX est inférieure à la tension de commande du transistor 108, c'est-à-dire la tension de référence GND. La tension grille-source du transistor 108 est donc positive. Le transistor 108 est donc passant durant la phase (B). Ainsi, la tension sur le noeud 112 a une valeur basse, par exemple sensiblement égale à la tension V3. Le signal POS, en sortie de l'inverseur 117, est cependant maintenu à la valeur basse. De préférence, le signal POS et le signal NEG sont maintenus à la valeur basse jusqu'à la fin de la phase de restitution d'énergie, par exemple jusqu'à un front descendant du signal GN. Par exemple, le maintien des signaux NEG et POS à la valeur basse durant les phases A, B et C est effectué par des éléments non représentés. Par exemple, le maintien des signaux NEG et POS à la valeur basse durant les phases A, B et C est effectué par le circuit 21.

Au cours de la phase (C), c'est-à-dire la phase de restitution d'énergie, le transistor 13 est passant et le transistor 9 est bloqué. Cela correspond, dans le mode de réalisation de la figure 3, au signal de commande GN ayant une valeur haute et au signal de commande GP ayant une valeur haute. La tension VLX croît, mais reste négative. Durant la phase (C), le courant Ic diminue, le noeud 11 n'étant plus alimenté par le rail 3.

La tension VLX étant inférieure à la tension de commande du transistor 110, c'est-à-dire la tension d'alimentation Vbat, la tension grille-source du transistor 110 est positive. Le transistor 110 reste donc bloqué durant la phase (C). Ainsi, la tension sur le noeud 114 a une valeur basse, par exemple sensiblement égale à la tension de référence GND. Le signal NEG, en sortie des inverseurs 120 et 122 a donc une valeur basse.

La tension VLX est négative. Autrement dit, la tension VLX est inférieure à la tension de commande du transistor 108, c'est-à-dire la tension de référence GND. La tension grille-source du transistor 108 est donc positive. Le transistor 108 est donc passant durant la phase (B). Ainsi, la tension sur le noeud 112 a une valeur basse, par exemple sensiblement égale à la tension V3. Le signal POS, en sortie de l'inverseur 117, est cependant maintenu à la valeur basse durant la phase (C) .

Au cours de la phase (D), le transistor 13 est bloqué et le transistor 9 est bloqué. Cela correspond, dans le mode de réalisation de la figure 1, au signal de commande GN ayant une valeur basse et au signal de commande GP ayant une valeur haute.

Comme en phase (B), le courant Ic est positif et les transistors 9 et 13 sont bloqués. Le courant Ic traverse donc la diode 220. La tension VLX prend la valeur V3 négative.

La tension VLX étant, comme en phase (B), inférieure à la tension de commande du transistor 110, c'est-à-dire la tension d'alimentation Vbat, la tension grille-source du transistor 110 est positive. Le transistor 110 reste donc bloqué durant la phase (B). Ainsi, la tension sur le noeud 114 a une valeur basse, par exemple sensiblement égale à la tension de référence GND. Le signal NEG, en sortie des inverseurs 120 et 122 a donc une valeur basse.

Comme en phase (B), la tension VLX est négative. Autrement dit, la tension VLX est inférieure à la tension de commande du transistor 108, c'est-à-dire la tension de référence GND. La tension grille-source du transistor 108 est donc positive. Le transistor 108 est donc passant durant la phase (B). Ainsi, la tension sur le noeud 112 a une valeur basse, par exemple sensiblement égale à la tension V3. Le signal POS, en sortie de l'inverseur 117, est cependant maintenu à la valeur basse, par exemple jusqu'au front descendant du signal GN.

Durant la phase (D), le courant Ic continue de diminuer. La phase (D) se termine lorsque le courant Ic atteint la valeur zéro. Durant la période (D), les signaux POS et NEG ne sont plus maintenus à la valeur basse. Ainsi, le signal POS prend la valeur haute. Le signal NEG a toujours la valeur basse.

La phase (D) est par exemple suivie d'une phase (E) correspondant par exemple à la phase (A) d'un cycle de fonctionnement suivant ou à une phase à l'arrêt.

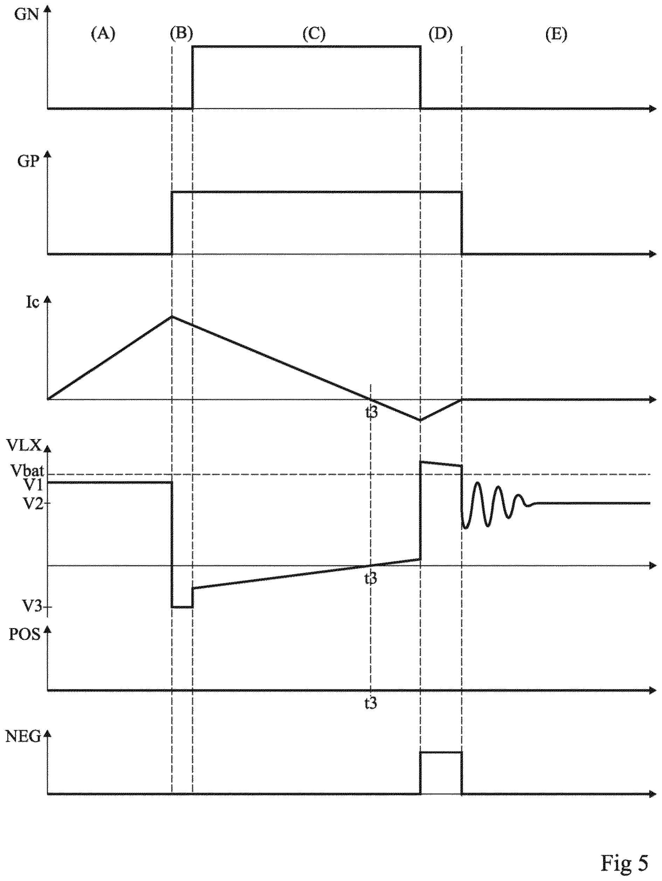

La figure 5 est un ensemble de chronogrammes illustrant le fonctionnement du circuit de la figure 3. Plus précisément, la figure 5 représente le comportement des signaux de commande GN, GP, du courant Ic, de la tension VLX sur le noeud 206, et les signaux POS et NEG, pendant un cycle de fonctionnement du circuit 20 de la figure 1. Le cycle de fonctionnement comprend, comme en figure 2, quatre phases : une phase (A) d'accumulation d'énergie dans l'élément inductif, une phase (B) intermédiaire, une phase (C) de restitution d'énergie, et une phase (D) de compensation.

Les phases (A) et (B) sont identiques aux phases (A) et (B) de la figure 4. Elles ne seront donc pas décrites de nouveau.

Au cours de la phase (C) de restitution d'énergie, le transistor 13 est passant et le transistor 9 est bloqué. Cela correspond, dans le mode de réalisation de la figure 1, au signal de commande GN ayant une valeur haute et au signal de commande GP ayant une valeur haute.

La tension VLX croît au cours de la phase (C). A un instant tz de la phase (C), la tension VLX atteint la valeur zéro, puis continue à croitre. Le courant Ic décroit durant la phase (C). A l'instant tz, le courant Ic atteint la valeur zéro. Durant la phase (C), le courant Ic est ainsi positif avant l'instant tz et négatif après l'instant tz et la tension VLX est négative avant l'instant tz, et positive après l'instant tz.

Durant la phase (C), la tension VLX est inférieure au premier seuil de tension Vbat. Ainsi, le signal NEG maintient la valeur basse. De plus, la tension VLX est inférieure au deuxième seuil de tension GND avant l'instant tz, et supérieure au deuxième seuil après l'instant tz. Durant la phase (C), le signal POS est maintenu à une valeur basse.

Au cours de la phase (D), le transistor 13 est bloqué et le transistor 9 est bloqué. Cela correspond, dans le mode de réalisation de la figure 3, au signal de commande GN ayant une valeur basse et au signal de commande GP ayant une valeur haute.

Les transistors 9 et 13 étant bloqués, et le courant Ic étant négatif, la diode 218 devient active. La tension VLX devient donc supérieure à la tension Vbat, par exemple sensiblement égale à la tension Vbat plus la tension de seuil de la diode 218. Ainsi, le courant Ic augmente jusqu'à atteindre zéro. Lorsque le courant atteint la valeur zéro, la phase (D) est terminée.

La tension VLX étant supérieure, par exemple d'une valeur sensiblement égale à un seuil de diode, à la tension de commande du transistor 110, c'est-à-dire la tension d'alimentation Vbat, le signal NEG a une valeur haute. De plus, La tension VLX est supérieure à la tension de commande du transistor 108, c'est-à-dire la tension de référence GND, le signal POS a une valeur basse.

La phase (D) est suivie d'une phase (E), dans laquelle le dispositif se comporte similairement à son comportement dans la phase (A). A titre de variante, la phase (E) correspond à une phase à l'arrêt.

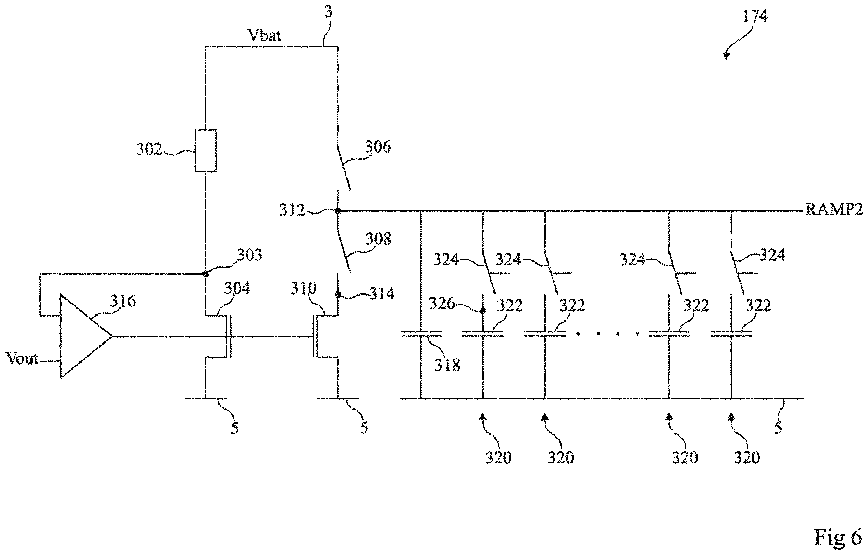

La figure 6 représente plus en détails une autre partie du mode de réalisation de la figure 1. La figure 6 représente plus en détails une partie du circuit 174 de génération des rampes de tension. Plus précisément, la figure 6 représente la partie du circuit 174 générant la rampe de tension dont la pente dépend du signal TRIM, c'est-à-dire la rampe RAMP2 dans l'exemple dont le fonctionnement est décrit en relation avec la figure 1.

Le circuit 174 comprend une résistance 302 et un transistor 304 reliés en série entre le noeud 3 d'application de la tension d'alimentation Vbat et le noeud 5 d'application d'une tension de référence GND. Plus précisément, une borne de la résistance 302 est reliée, de préférence connectée, au noeud 3 et une autre borne de la résistance 302 est reliée, de préférence connectée, à un noeud 303. Une borne de conduction, par exemple le drain, du transistor 304 est reliée, de préférence connectée, au noeud 303 et une autre borne de conduction, par exemple la source, du transistor 304 est reliée, de préférence connectée, au noeud 5.

Le circuit 174 comprend, en outre, des interrupteurs 306 et 308 en série avec un transistor 310. Plus précisément, une borne de l'interrupteur 306 est reliée, de préférence connectée, au noeud 3 et une autre borne de l'interrupteur 306 est reliée, de préférence connectée, à un noeud 312. Une borne de l'interrupteur 308 est reliée, de préférence connectée, au noeud 312 et une autre borne de l'interrupteur 308 est reliée, de préférence connectée, à un noeud 314. Une borne de conduction, par exemple le drain, du transistor 310 est reliée, de préférence connectée, au noeud 314 et une autre borne de conduction, par exemple la source, du transistor 310 est reliée, de préférence connectée, au noeud 5.

Ainsi, l'ensemble comprenant la résistance 302 et le transistor 304 est en parallèle avec l'ensemble comprenant les interrupteurs 306, 308 et le transistor 310.

De préférence, les transistors 304 et 310 sont de même type, par exemple des transistors MOS à canal N. Par exemple, les transistors 304 et 310 sont identiques. Les bornes de commande des transistors 304 et 310 sont reliées, de préférence connectées, l'une à l'autre.

Le circuit 174 comprend, en outre, un amplificateur opérationnel 316. L'amplificateur opérationnel 316 reçoit sur une entrée la tension Vout et sur une autre entrée la tension sur le noeud 303. Autrement dit, l'amplificateur opérationnel 316 comprend une entrée reliée, de préférence connectée, au noeud 2 (figure 1) et une autre entrée reliée, de préférence connectée, au noeud 303. L'amplificateur opérationnel fournit en sortie le signal de commande des transistors 304 et 310. Ainsi, l'amplificateur opérationnel comprend une sortie reliée, de préférence connectée, aux bornes de commande des transistors 304 et 310.

Le circuit 174 comprend en outre un condensateur, ou circuit capacitif, à capacité variable. Autrement dit, le circuit 174 comprend au moins deux condensateurs reliés entre le noeud 312 et le noeud 5. Plus précisément, le circuit 174 comprend un transistor 318 relié entre le noeud 312 et le noeud 5. Une borne du condensateur 318 est reliée, de préférence connectée, au noeud 312 et une autre borne du condensateur 318 est reliée, de préférence connectée, au noeud 5. Ainsi, le condensateur 318 est chargé chaque fois que le circuit 174 génère une rampe de tension.

Le circuit 174 comprend au moins un ensemble 320. Chaque ensemble 320 comprend un condensateur 322 et un interrupteur 324 reliés en série entre le noeud 312 et le noeud 5. Plus précisément, dans chaque ensemble 320, une borne du condensateur 322 est reliée, de préférence connectée, au noeud 5 et une autre borne du condensateur est reliée, de préférence connectée, à une borne de l'interrupteur 324, l'autre borne de l'interrupteur 324 étant reliée, de préférence connectée, au noeud 312. De préférence, les condensateurs 322 sont identiques entre eux et identiques au condensateur 318.

Lors de la génération de la rampe de tension RAMP2, l'interrupteur 306 est fermé et l'interrupteur 308 est ouvert, de manière à charger le condensateur 318 et les condensateurs 322 d'ensemble dont l'interrupteur 324 est fermé. La valeur de capacité globale des condensateurs chargés détermine la pente de la rampe de tension RAMP2. Ainsi, plus le nombre d'interrupteurs fermés est important, plus la capacité globale est importante, et plus la pente de la rampe RAMP2 est faible.

Les états des interrupteurs 324 sont déterminés par le signal TRIM. Ainsi, le signal TRIM détermine le nombre d'interrupteurs ouverts et fermés. Le signal TRIM détermine ainsi la pente de la rampe RAMP2. Par exemple, si la valeur du signal TRIM augmente, le nombre d'interrupteurs 324 ouverts augmente, ou inversement, plus la valeur du signal TRIM est importante, plus le nombre d'interrupteurs 324 ouvert diminue. Par exemple, si la valeur du signal TRIM augmente d'un pas, par exemple 1, un interrupteur 324 est ouvert et si la valeur du signal TRIM diminue d'un pas, par exemple 1, un interrupteur 324 est fermé. De préférence, un seul interrupteur 324 peut être fermé ou ouvert d'un cycle à l'autre. De préférence, lors du démarrage du convertisseur 1, une moitié des interrupteurs 324 sont ouverts et l'autre moitié des interrupteurs sont fermés.

Par exemple, le circuit 174 comprend un circuit non représenté configuré pour convertir le signal TRIM, en un mot binaire, comprenant par exemple un bit pour chaque interrupteur 324.

A titre de variante, le condensateur 318 peut être remplacé par un ensemble 320.

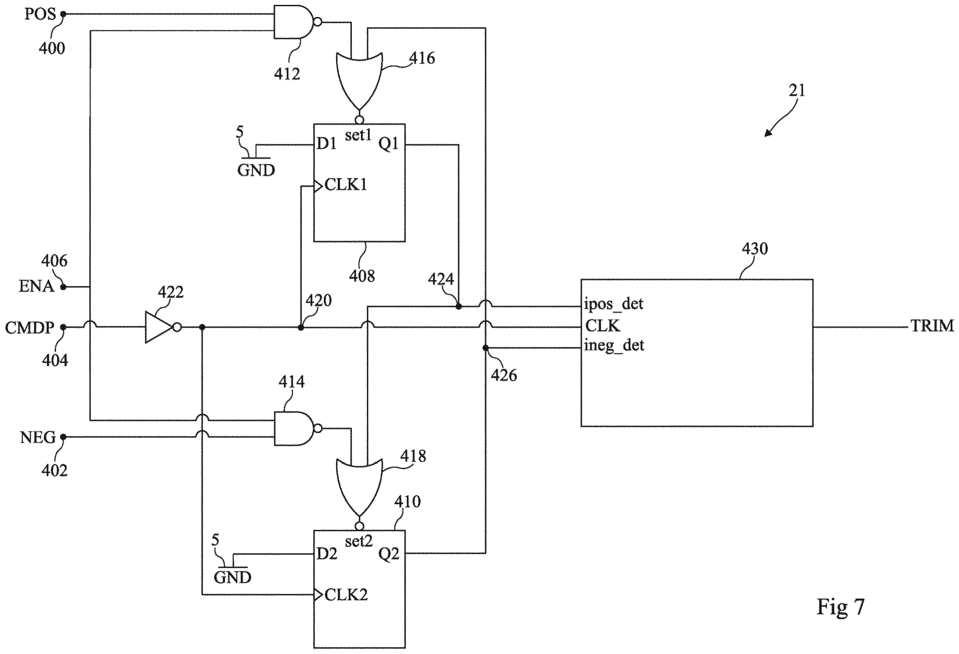

La figure 7 représente plus en détails une partie du mode de réalisation de la figure 1. Plus précisément, la figure 7 représente un exemple d'implémentation du circuit 21.

Le circuit 21 reçoit sur des entrées 400 et 402 respectivement les signaux POS et NEG. Le circuit 21 reçoit, de plus, le signal CMDP sur une entrée 404. Le circuit 21 reçoit en outre un signal ENA sur une entrée 406. Le signal ENA est un signal binaire de démarrage du convertisseur 1. Autrement dit, lorsque le signal ENA est à une première valeur binaire, de préférence la valeur 0, le convertisseur est éteint, et lorsque le signal ENA a une deuxième valeur binaire, de préférence la valeur 1, le convertisseur 1 est en fonctionnement. Ainsi, lors du fonctionnement du circuit 21, le signal ENA a une valeur constante égale à 1.

Le circuit 21 comprend deux bascules D 408 et 410. Le circuit 21 comprend en outre deux portes logiques NON ET 412 et 414, et deux portes logiques OU 416 et 418.

La bascule 408 comprend une entrée D1 de données sur laquelle est fournie la tension de référence GND. Autrement dit, l'entrée D1 de la bascule 408 est reliée, de préférence connectée, au noeud 5. Autrement dit, l'entrée D1 reçoit, de manière constante durant le fonctionnement du circuit 21, en entrée la valeur binaire 0.

La bascule 408 comprend une entrée CLK1 d'horloge. L'entrée CLK1 est reliée, de préférence connectée, à un noeud 420 sur lequel est fourni le signal complémentaire du signal de commande CMDP. Ainsi, le noeud 404 est relié au noeud 420 par un circuit inverseur 422. Une entrée du circuit 422 est reliée, de préférence connectée, au noeud 404 et une sortie du circuit 422 est reliée, de préférence connectée, au noeud 420.

La bascule 408 comprend une sortie Q1 reliée, de préférence connectée, à un noeud 424.

Similairement, la bascule 410 comprend une entrée D2 de données sur laquelle est fournie la tension de référence GND. Autrement dit, l'entrée D2 de la bascule 410 est reliée, de préférence connectée, au noeud 5. Autrement dit, l'entrée D2 reçoit, de manière constante durant le fonctionnement du circuit 21, en entrée la valeur binaire 0.

La bascule 410 comprend une entrée CLK2 d'horloge. L'entrée CLK2 est reliée, de préférence connectée, au noeud 420 sur lequel est fourni le signal complémentaire du signal de commande CMDP.

La bascule 410 comprend une sortie Q2 reliée, de préférence connectée, à un noeud 426.

Les bascules 408 et 410 comprennent en outre respectivement des entrées de mise à 1 set1 et set2 actives à zéro, c'est-à-dire que la sortie Q1 ou Q2 est mise à 1 si le signal sur l'entrée respective est égal à zéro. L'entrée set1 est reliée, de préférence connectée, à une sortie de la porte OU 416. Une entrée de la porte 416 est reliée, de préférence connectée, au noeud 426 et une autre entrée de la porte OU 416 est reliée, de préférence connectée, à une sortie de la porte NON ET 412. Une entrée de la porte NON ET 412 est reliée, de préférence connectée, au noeud 400 et une autre entrée de la porte NON ET 412 est reliée, de préférence connectée, au noeud 406.

L'entrée set2 est reliée, de préférence connectée, à une sortie de la porte OU 418. Une entrée de la porte 418 est reliée, de préférence connectée, au noeud 424 et une autre entrée de la porte OU 418 est reliée, de préférence connectée, à une sortie de la porte NON ET 414. Une entrée de la porte NON ET 414 est reliée, de préférence connectée, au noeud 402 et une autre entrée de la porte NON ET 414 est reliée, de préférence connectée, au noeud 406.

Ainsi, à chaque front montant du signal CMDP, c'est-à-dire au début de chaque phase d'accumulation d'énergie, c'est-à-dire à la fin de chaque cycle :
- la valeur binaire sur le noeud 424, c'est-à-dire un signal ipos_det, prend la valeur 1 si le signal POS a la valeur 1, le signal ENA a la valeur 1 et si la valeur binaire sur le noeud 426 est égale à 0, c'est-à-dire si le circuit 19 détermine que le courant dans l'inductance 15 est positif, si le circuit 21 est en fonctionnement et si le circuit 19 n'a pas déterminé que le courant dans l'inductance est négatif ;
- la valeur binaire sur le noeud 424, c'est-à-dire un signal ipos_det, prend la valeur 0 si le signal POS ou le signal ENA est a la valeur 0, ou si la valeur binaire sur le noeud 426 est égale à 1, c'est-à-dire si le circuit 19 ne détermine pas que le courant dans l'inductance 15 est positif, ou si le circuit 21 n'est pas en fonctionnement ou si le circuit 19 détermine que le courant dans l'inductance est négatif
- la valeur binaire sur le noeud 426, c'est-à-dire un signal ineg_det, prend la valeur 1 si le signal NEG a la valeur 1, le signal ENA a la valeur 1 et si la valeur binaire sur le noeud 424 est égale à 0, c'est-à-dire si le circuit 19 détermine que le courant dans l'inductance 15 est négatif, si le circuit 21 est en fonctionnement et si le circuit 19 n'a pas déterminé que le courant dans l'inductance est positif ; et
- la valeur binaire sur le noeud 426, c'est-à-dire un signal ineg_det, prend la valeur 0 si le signal NEG ou le signal ENA est a la valeur 0, ou si la valeur binaire sur le noeud 424 est égale à 1, c'est-à-dire si le circuit 19 ne détermine pas que le courant dans l'inductance 15 est négatif, ou si le circuit 21 n'est pas en fonctionnement ou si le circuit 19 détermine que le courant dans l'inductance est positif.

De préférence, les signaux ipos_det et ineg_det ne peuvent pas être égaux à 1 au même instant. Si les signaux ipos_det et ineg_det sont égaux à 1 au même instant, cette information n'est pas prise en compte par le circuit 430. Si le signal POS prend la valeur 1 alors que le signal ineg_det a déjà la valeur 1, une entrée de la porte OU 416 est déjà à 1 et donc le passage à 1 du signal POS ne change pas la valeur en sortie de 416 et le signal ipos_det ne peut pas passer à 1. Similairement, si le signal NEG prend la valeur 1 alors que le signal ipos_det a déjà la valeur 1, une entrée de la porte OU 418 est déjà à 1 et donc le passage à 1 du signal NEG ne change pas la valeur en sortie de 418 et le signal ineg_det ne peut pas passer à 1.

Le circuit 21 comprend, en outre un circuit 430. Le circuit 430 reçoit en entrée les signaux ipos_det, ineg_det. Autrement dit, le circuit 430 comprend une entrée reliée, de préférence connectée, au noeud 424 et une entrée reliée, de préférence connectée, au noeud 426. De plus, le circuit 430 comprend une entrée d'horloge CLK sur laquelle le circuit 430 reçoit le signal complémentaire du signal CMDP. Autrement dit, l'entrée CLK du circuit 430 est reliée, de préférence connectée, au noeud 420. Le circuit 430 comprend en outre une sortie sur laquelle est fourni le signal TRIM. Le signal TRIM est par exemple fourni sur un bus de données à plusieurs bits, par exemple à 5 bits.

Le circuit 430 est configuré pour modifier la valeur du signal TRIM selon les valeurs des signaux ipos_det et ineg_det. Par exemple, le circuit 430 est un compteur configuré pour, à chaque front descendant du signal complémentaire du signal CMDP, c'est-à-dire à chaque front montant du signal CMDP, c'est-à-dire au début de chaque cycle, diminuer la valeur du signal TRIM d'un pas, de préférence de 1, si le signal ipos_det a la valeur 1 et augmenter la valeur du signal TRIM si le signal ineg_det a la valeur 1. De préférence, si la valeur du signal TRIM atteint la valeur minimale, par exemple la valeur 0, et si le signal ipos_det a la valeur 1, la valeur du signal TRIM n'est pas modifiée. Similairement, si la valeur du signal TRIM atteint la valeur maximale, et si le signal ineg_det a la valeur 1, la valeur du signal TRIM n'est pas modifiée. De plus, si les signaux ipos_det et ineg_det sont simultanément à la valeur 1, la valeur du signal TRIM n'est pas modifiée.

De manière plus générale, le circuit 21 est configuré pour détecter à un instant donné, par exemple le début d'un cycle correspondant par exemple à un front montant du signal de commande du transistor 9, l'état des signaux POS et NEG de manière à modifier le signal TRIM. Cela est effectué à l'aide de bascules D, et en particulier en fournissant les signaux POS et NEG aux entrées asynchrones de mise à 1 (SET) des bascules, les bascules étant remise à 0 au front descendant du signal CMDP de chaque cycle.

De préférence, le dispositif 1 est configuré pour qu'un front montant du signal CMDP ne survienne pas en même temps que les signaux POS et NEG ont une valeur haute, c'est-à-dire une valeur 1.

Un avantage des modes de réalisation décrits est qu'il permet d'obtenir un courant traversant l'inductance nul en fin de cycle.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Convertisseur de tension DC/DC comprenant une inductance et un circuit de commande (17), le circuit de commande (17)étant configuré pour mettre en oeuvre, ou commander, une succession de cycles de fonctionnement du convertisseur (1) chaque cycle comprenant une phase d'accumulation d'énergie dans l'inductance et une phase de restitution d'énergie, le circuit de commande (17) étant configuré pour que la durée de la phase de restitution d'énergie soit déterminée par la comparaison d'une rampe de tension (RAMP2) et une première tension de référence (Vref), le circuit de commande (17) étant configuré pour que, si le courant dans l'inductance (15) est positif à la fin du cycle de fonctionnement précédent, la pente de ladite rampe de tension (RAMP2) est modifiée de manière à avoir une inclinaison plus faible ou pour que, si le courant dans l'inductance (15) est négatif à la fin du cycle de fonctionnement précédent, la pente de ladite rampe de tension (RAMP2) est modifiée de manière à avoir une inclinaison plus importante.

2. Procédé de commande d'un convertisseur de tension DC/DC (1) comprenant une succession de cycles de fonctionnement, chaque cycle comprenant une phase d'accumulation d'énergie dans une inductance et une phase de restitution d'énergie, la durée de la phase de restitution d'énergie étant déterminée par la comparaison d'une rampe de tension (RAMP1, RAMP2) et une première tension de référence (Vref), dans lequel, si le courant dans l'inductance (15) est positif à la fin du cycle de fonctionnement précédent, la pente de ladite rampe de tension (RAMP2) est modifiée de manière à avoir une inclinaison plus faible ou si le courant dans l'inductance (15) est négatif à la fin du cycle de fonctionnement précédent, la pente de ladite rampe de tension (RAMP2) est modifiée de manière à avoir une inclinaison plus importante.

3. Convertisseur selon la revendication 1 ou procédé selon la revendication 2, dans lequel le convertisseur comprend des premier (9) et deuxième (13) transistors reliés en série entre un premier noeud (3) d'application d'une tension d'alimentation (VDD) et un deuxième noeud (5) d'application d'une deuxième tension de référence (GND), les premier (9) et deuxième (13) transistors étant reliés l'un à l'autre par un troisième noeud (11), le troisième noeud (11) étant relié à un quatrième noeud de sortie (2) par l'inductance (15), le quatrième noeud de sortie étant relié au deuxième noeud d'application (5) de la deuxième tension de référence (GND) par un premier condensateur (16).

4. Convertisseur ou procédé selon la revendication 3, dans lequel le convertisseur comprend un premier circuit (19) relié au troisième noeud (11) configuré pour déterminer le signe du courant traversant l'inductance (15).

5. Convertisseur ou procédé selon la revendication 4, dans lequel le premier circuit comprend des troisième (108) et quatrième (110) transistors reliés en série entre des cinquième (112) et sixième (114) noeuds, les troisième et quatrième transistors étant reliés l'un à l'autre par un septième noeud (102) relié au troisième noeud (11), le cinquième noeud (112) étant relié au premier noeud d'application (3) de la tension d'alimentation (Vbat) par un premier élément résistif (116), et le sixième noeud (114) est relié au deuxième noeud d'application (5) de la tension de référence (GND) par un deuxième élément résistif (118), la borne de commande du troisième transistor (108) étant reliée au deuxième noeud, et la borne de commande du quatrième transistor (110) est reliée à un premier noeud, le deuxième circuit (10) comprenant :
- un huitième noeud de sortie (106) sur lequel est fourni un premier signal (NEG) prenant une première valeur lorsque la tension (VLX) sur le troisième noeud est supérieure à la première tension d'alimentation (Vbat) et une deuxième valeur lorsque la tension (VLX) sur le troisième noeud est inférieure à la première tension d'alimentation (Vbat) ; et
- un neuvième noeud de sortie (104) sur lequel est fourni un deuxième signal (POS) prenant une première valeur lorsque la tension (VLX) sur le troisième noeud est inférieure à la deuxième tension (GND) et une deuxième valeur lorsque la tension sur le troisième noeud est supérieure à la deuxième tension.

6. Convertisseur selon l'une quelconque des revendications 1, 3 à 5 ou procédé selon l'une quelconque des revendications 2 à 5, dans lequel le convertisseur comprend un deuxième circuit (174) configuré pour générer la rampe de tension, la pente de la rampe de tension étant dépendante d'un troisième signal (TRIM).

7. Convertisseur ou procédé selon la revendication 6, dans lequel le deuxième circuit (174) comprend un circuit capacitif à capacité variable configuré pour être chargé lors de la génération de la rampe (RAMP2), la capacité du circuit dépendant de la valeur du troisième signal.

8. Convertisseur ou procédé selon la revendication 6 ou 7, dans lequel le troisième signal (TRIM) a un nombre fini de valeur possibles, chaque valeur du signal correspondant à une valeur de capacité.

9. Convertisseur ou procédé selon l'une quelconque des revendications 6 à 8, dans lequel le convertisseur comprend un troisième circuit configuré pour déterminer la modification du troisième signal selon les valeurs des premier et deuxième signaux.

## Patentansprüche

1. Gleichspannungswandler mit einer Induktivität und einer Steuerschaltung (17), wobei die Steuerschaltung (17) konfiguriert ist zum Implementieren oder Steuern einer Folge von Betriebszyklen des Wandlers (1), wobei jeder Zyklus eine Phase der Energieakkumulation in der Induktivität und eine Phase der Energierückgabe aufweist, wobei die Steuerschaltung (17) so konfiguriert ist, dass die Dauer der Energierückgabephase durch den Vergleich einer Spannungsrampe (RAMP2) und einer ersten Referenzspannung (Vref) bestimmt wird, wobei die Steuerschaltung (17) so konfiguriert ist, dass, wenn der Strom in der Induktivität (15) am Ende des vorhergehenden Betriebszyklus positiv ist, die Steigung der Spannungsrampe (RAMP2) so geändert wird, dass sie eine geringere Neigung aufweist, oder dass, wenn der Strom in der Induktivität (15) am Ende des vorhergehenden Betriebszyklus negativ ist, die Steigung der Spannungsrampe (RAMP2) so geändert wird, dass sie eine höhere Neigung aufweist.

2. Verfahren zum Steuern eines Gleichspannungswandlers (1), aufweisend eine Folge von Betriebszyklen, wobei jeder Zyklus eine Phase der Energieakkumulation in einer Induktivität und eine Phase der Energierückgabe aufweist, wobei die Dauer der Energierückgabephase durch den Vergleich einer Spannungsrampe (RAMP1, RAMP2) und einer ersten Referenzspannung (Vref) bestimmt wird, wobei wenn der Strom in der Induktivität (15) am Ende des vorherigen Betriebszyklus positiv ist, die Steigung der Spannungsrampe (RAMP2) so geändert wird, dass sie eine geringere Neigung aufweist, oder so, dass, wenn der Strom in der Induktivität (15) am Ende des vorherigen Betriebszyklus negativ ist, die Steigung der Spannungsrampe (RAMP2) so geändert wird, dass sie eine höhere Neigung aufweist.

3. Wandler nach Anspruch 1 oder Verfahren nach Anspruch 2, wobei der Wandler einen ersten (9) und einen zweiten (13) Transistor aufweist, die in Reihe zwischen einem ersten Knoten (3) zum Anlegen einer Versorgungsspannung (VDD) und einem zweiten Knoten (5) zum Anlegen einer zweiten Referenzspannung (GND) geschaltet sind, wobei der erste (9) und der zweite (13) Transistor über einen dritten Knoten (11) miteinander verbunden sind, wobei der dritte Knoten (11) über die Induktivität (15) mit einem vierten Ausgangsknoten (2) verbunden ist, wobei der vierte Ausgangsknoten über einen ersten Kondensator (16) mit dem zweiten Knoten (5) zum Anlegen der zweiten Referenzspannung (GND) verbunden ist.

4. Wandler oder Verfahren nach Anspruch 3, wobei der Wandler eine erste Schaltung (19) aufweist, die mit dem dritten Knoten (11) verbunden ist und die konfiguriert ist zum Bestimmen des Vorzeichens des durch die Induktivität (15) fließenden Stroms.

5. Wandler oder Verfahren nach Anspruch 4, wobei die erste Schaltung einen dritten (108) und einen vierten (110) Transistor aufweist, die zwischen einem fünften (112) und einem sechsten (114) Knoten in Reihe geschaltet sind, wobei der dritte und der vierte Transistor über einen siebten Knoten (102), der mit dem dritten Knoten (11) verbunden ist, miteinander verbunden sind, wobei der fünfte Knoten (112) mit dem ersten Knoten (3) zum Anlegen der Versorgungsspannung (Vbat) über ein erstes Widerstandselement (116) verbunden ist, und der sechste Knoten (114) mit dem zweiten Knoten (5) zum Anlegen der Referenzspannung (GND) über ein zweites Widerstandselement (118) verbunden ist, wobei der Steueranschluss des dritten Transistors (108) mit dem zweiten Knoten verbunden ist, und der Steueranschluss des vierten Transistors (110) mit einem ersten Knoten verbunden ist, wobei die zweite Schaltung (10) Folgendes aufweist:
- einen achten Ausgangsknoten (106), an dem ein erstes Signal (NEG) bereitgestellt wird, das einen ersten Wert annimmt, wenn die Spannung (VLX) an dem dritten Knoten größer als die erste Versorgungsspannung (Vbat) ist, und einen zweiten Wert, wenn die Spannung (VLX) an dem dritten Knoten kleiner als die erste Versorgungsspannung (Vbat) ist; und
- einen neunten Ausgangsknoten (104), an dem ein zweites Signal (POS) bereitgestellt wird, das einen ersten Wert annimmt, wenn die Spannung (VLX) an dem dritten Knoten kleiner als die zweite Spannung (GND) ist, und einen zweiten Wert, wenn die Spannung an dem dritten Knoten größer als die zweite Spannung ist.

6. Wandler nach einem der Ansprüche 1, 3 bis 5 oder Verfahren nach einem der Ansprüche 2 bis 5, wobei der Wandler eine zweite Schaltung (174) aufweist, die konfiguriert ist zum Erzeugen der Spannungsrampe, wobei die Steigung der Spannungsrampe von einem dritten Signal (TRIM) abhängt.

7. Wandler oder Verfahren nach Anspruch 6, wobei die zweite Schaltung (174) eine kapazitive Schaltung mit einer variablen Kapazität aufweist, die so konfiguriert ist, dass sie bei der Erzeugung der Rampe (RAMP2) geladen wird, wobei die Kapazität der Schaltung von dem Wert des dritten Signals abhängt.

8. Wandler oder Verfahren nach Anspruch 6 oder 7, wobei das dritte Signal (TRIM) eine endliche Anzahl möglicher Werte hat, wobei jeder Signalwert einem Kapazitätswert entspricht.

9. Wandler oder das Verfahren nach einem der Ansprüche 6 bis 8, wobei der Wandler eine dritte Schaltung aufweist, die konfiguriert ist zum Bestimmen der Änderung des dritten Signals gemäß den Werten der ersten und zweiten Signale.

## Claims

1. DC/DC voltage converter comprising an inductor and a control circuit (17), the control circuit (17) being configured to implement, or control, a succession of operating cycles of the converter (1), each cycle comprising an energy accumulation phase in the inductor and an energy restitution phase, the control circuit (17) being configured so that the duration of the energy restitution phase is determined by comparing a voltage ramp (RAMP2) and a first reference voltage (Vref), the control circuit (17) being configured so that, if the current in the inductor (15) is positive at the end of the previous operating cycle, the slope of said voltage ramp (RAMP2) is changed so as to have a lower tilt, or so that, if the current in the inductor (15) is negative at the end of the previous operating cycle, the slope of said voltage ramp (RAMP2) is changed so as to have a higher tilt.

2. Method for controlling a DC/DC voltage converter (1) comprising a succession of operating cycles, each cycle comprising an energy accumulation phase in an inductor and an energy restitution phase, the duration of the energy restitution phase being determined by comparing a voltage ramp (RAMP1, RAMP2) and a first reference voltage (Vref), wherein, if the current in the inductor (15) is positive at the end of the previous operating cycle, the slope of said voltage ramp (RAMP2) is changed so as to have a lower tilt, or so that, if the current in the inductor (15) is negative at the end of the previous operating cycle, the slope of said voltage ramp (RAMP2) is changed so as to have a higher tilt.

3. Converter according to claim 1 or a method according to claim 2, wherein the converter comprises first (9) and second (13) transistors coupled in series between a first node (3) for applying a supply voltage (VDD) and a second node (5) for applying a second reference voltage (GND), the first (9) and second (13) transistors being coupled to each other by a third node (11), the third node (11) being coupled to a fourth output node (2) by the inductor (15), the fourth output node being coupled to the second node (5) for applying the second reference voltage (GND) by a first capacitor (16).

4. Converter or method according to claim 3, wherein the converter comprises a first circuit (19) coupled to the third node (11) configured to determine the sign of the current flowing through the inductor (15).

5. Converter or method according to claim 4, wherein the first circuit comprises the third (108) and fourth (110) transistors coupled in series between fifth (112) and sixth (114) nodes, the third and fourth transistors being coupled to each other by a seventh node (102) coupled to the third node (11), the fifth node (112) being coupled to the first node (3) for applying the supply voltage (Vbat) by a first resistor element (116), and the sixth node (114) is coupled to the second node (5) for applying the reference voltage (GND) by a second resistor element (118), the control terminal of the third transistor (108) being coupled to the second node, and the control terminal of the fourth transistor (110) is coupled to a first node, the second circuit (10) comprising :
- an eighth output node (106) at which a first signal (NEG) is provided that takes a first value when the voltage (VLX) at the third node is greater than the first supply voltage (Vbat) and a second value when the voltage (VLX) at the third node is less than the first supply voltage (Vbat); and
- a ninth output node (104) on which a second signal (POS) is provided that takes a first value when the voltage (VLX) on the third node is less than the second voltage (GND) and a second value when the voltage on the third node is greater than the second voltage.

6. Converter according to any one of claims 1, 3 to 5 or method according to any one of claims 2 to 5, wherein the converter comprises a second circuit (174) configured to generate the voltage ramp, the slope of the voltage ramp depending on a third signal (TRIM).

7. Converter or method according to claim 6, wherein the second circuit (174) comprises a capacitive circuit with a variable capacitance configured to be charged upon generation of the ramp (RAMP2), the capacitance of the circuit depending on the value of the third signal.

8. Converter or method according to claim 6 or 7, wherein the third signal (TRIM) has a finite number of possible values, each signal value corresponding to a capacitance value.

9. The converter or method according to any one of claims 6 to 8, wherein the converter comprises a third circuit configured to determine the change in the third signal according to the values of the first and second signals.
